# EUROPÄISCHE PATENTSCHRIFT

(11) **EP 0 413 045 B1**
(45) Veröffentlichungstag und Bekanntmachung des Hinweises auf die Patenterteilung: **23.06.1993**
(21) Anmeldenummer: 89115145.8
(22) Anmeldetag: 17.08.1989
(51) Int. Cl.: H05K 1/00

(54) **Elektrische Leiterplatte**
Electrical circuit board
Plaque de circuit électrique

(43) Veröffentlichungstag der Anmeldung: 20.02.1991
(73) Patentinhaber: Georg Schlegel GmbH & Co., D-88525 Dürmentingen (DE)
(72) Erfinder: Schlegel, Eberhard, D-7948 Dürmentingen (DE); Jerabek, Karl, A-1120 Wien (AT)
(74) Vertreter: Patentanwälte Eisele, Otten & Roth

(56) Entgegenhaltungen:
- EP-A- 0 299 380
- DE-A- 2 912 940
- US-A- 3 780 431

## Beschreibung

Die Erfindung betrifft eine elektrische Leiterplatte, die dazu dient, wenigstens ein elektrisches Schaltungselement mit einer Anschlußeinrichtung durch Leitungsbahnen zu verbinden. Als Anschlußeinrichtung kommen beispielsweise Klemmleisten, Lötfahnenleisten, mehrpolige Steckverbindungsteile o. dgl. in Betracht oder auch nur am Plattenrand in bestimmten Abständen endende Leitungsbahnen, auf die kontaktbildende Federleisten aufgesteckt werden. Unter Schaltungselementen in diesem Zusammenhang werden einerseits Schalter oder stromsteuernde Elemente und andererseits reine Stromverbraucher verstanden. In Betracht kommen hier z. B. Mikroschalter und Taster als Schließer oder Öffner, Befehlstaster mit Schaltapparaten, die mehrere Kontakte enthalten, Potentiometer, Lampen, Widerstände usw. Die Anordnung kann so getroffen sein, daß die Leiterplatte die darauf befindlichen Schaltungselemente und Anschlußeinrichtungen trägt oder, beispielsweise im Falle eines Befehlstasters, dieser an einem Schaltpult oder einer Gehäusewandung befestigt ist und seinerseits die Leiterplatte mit der Anschlußeinrichtung trägt.

Nicht selten werden solche mit nur wenigen Schaltungselementen bestückte Leiterplatten zu mehreren in einer Reihe angeordnet siehe beispielsweise die US-A-3 780 431. Diese reihenweise Montage ist jedoch sehr mühsam, da die Leiterplatten alle einzeln angefügt, ausgerichtet und elektrisch angeschlossen werden müssen.

Falls in bestimmten Anwendungsfällen mehrere gleiche Schaltungselemente nebeneinander erforderlich sind, mag es angebracht sein, diese auf eine einzige Leiterplatte zu setzen und mit einer gemeinsamen Anschlußeinrichtung zu versehen. Dies ist jedoch nur bei einem Bedarf mit großen Stückzahlen gleicher Schaltungselemente rationell. Schwankt jedoch die Anzahl der in einer Reihe anzuordnenden Schaltungselemente, so scheiden vorgeplante, einstückige Leiterplatten aus.

Der Erfindung liegt die Aufgabe zugrunde, anzugeben, wie Leiterplatten der einleitend umschriebenen Art in unterschiedlich langen Reihen einfach montiert und wie außerdem Vorteile bei der Lagerhaltung, dem Transport und der Handhabung erzielt werden können.

Diese Aufgabe wird bei einer elektrischen Leiterplatte erfindungsgemäß dadurch gelöst, daß diese streifenförmig ausgebildet ist und mehrere gleich große Leiterplattenbereiche aufweist, die durch Solltrennzonen quer abgeteilt und je mit wenigstens einem Schaltungselement und einer Anschlußeinrichtung bestückt sind, und daß die Schaltungselemente und die Anschlußeinrichtungen jedes Leiterplattenbereichs durch Leitungsbahnen miteinander verbunden sind. Diese Streifen kann man durch Abtrennen einzelner Leiterplattenbereiche an den Solltrennzonen auf die gewünschte Länge kürzen, wobei das Abtrennen als Abbrechen, Absägen oder je nach Ausbildung der Solltrennzonen auf andere Weise erfolgen kann. Das schließt nicht aus, daß einzelne oder mehrere zusammenhängende Leiterplattenbereiche, die als Reststücke übrigbleiben, ebenfalls nebeneinander in einer Reihe montiert werden können, also verwendbar bleiben. Längere Streifen von 10, 20 oder mehr Leiterplattenbereichen sind leicht und übersichtlich zu lagern, zu transportieren und zu montieren.

Die Solltrennzonen oder -linien können durch eine Perforation oder eine Nut gebildet sein, welche örtlich die Dicke der Leiterplatte verringert. Vorzugsweise werden die Leiterbahnabschnitte durch eine Linie bildende Fensterschlitze voneinander getrennt, wobei diese Schlitze in Abständen durch schmale Verbindungsstege unterbrochen sind. Beim Knicken der Platte brechen diese schmalen Verbindungsstege ab.

Was den Anschluß der Zuleitungen angeht, wurde vorstehend jede Leiterplatte für sich gesehen, da jede eine Anschlußeinrichtung mit der erforderlichen Anzahl von Anschlußelementen enthält. Beispielsweise müssen an einer Leiterplatte mit einem Schließerkontakt und einer Rückmeldelampe vier Drähte angeschlossen werden. Zwei davon werden als Brücken über die entsprechenden Elemente der Anschlußeinrichtungen aller Leiterplattenbereiche geschleift.

Um dies zu vermeiden und die Verdrahtungsarbeit zu vereinfachen, wird vorgeschlagen, daß gemeinsame, über die Solltrennzonen geführte Leitungsbahnen vorgesehen sind, an denen einander entsprechende Schaltungselemente aller Leiterplattenbereiche zusätzlich angeschlossen sind. Diese Leitungsbahnen bilden dann z. B. den gemeinsamen Minusanschluß oder "Schalterdraht" und sind wahlweise über jede Anschlußeinrichtung von außen erreichbar. Das bedeutet, daß nur an einem einzigen von allen zusammenhängenden Leiterplattenbereichen des ganzen Streifens ein äußerer Zuleitungsdraht angeschlossen werden muß und alle anderen Leiterplattenbereiche über die entsprechende durchgehende Leitungsbahn versorgt werden.

Vielfach enthalten die Leiterplattenbereiche auch als Öffner wirkende Schalter, die allesamt miteinander in Reihe zu einer sogenannten Ruhestromschaltung verbunden werden müssen. Dazu sind von einer Anschlußvorrichtung zur anderen Verbindungsbrücken zu setzen. Dies erübrigt sich nach dem weiteren Vorschlag, daß über die Solltrennzonen geführte Leitungsbahnen vorgesehen sind, die einander entsprechende Schaltungselemente aller Leiterplattenbereiche zu einer Reihenschaltung verbinden.

Die beiden zuletzt genannten Vorschläge vermeiden Schaltungsfehler und beschleunigen die Verdrahtungsarbeit beträchtlich. Wird der Leiterplattenstreifen an einer Solltrennzone abgeteilt, bedeutet dies selbstverständlich auch ein Abtrennen der durchgehenden Leitungsbahnen. Da diese üblicherweise aber sehr dünn sind, erschweren sie den Trennvorgang nicht. Besonders breite, für höhere Ströme ausgelegte gemeinsame Leitungsbahnen können im Bereich der Solltrennzonen in mehrere parallele Zweigbahnen geringeren Querschnitts aufgeteilt werden. Gemeinsame Leiterbahnen können auf beiden Seiten der Leiterplatte angebracht sein. Es ist somit möglich, beispielsweise zwei Leiterbahnen über einen schmalen Steg zu führen, nämlich auf jeder Plattenseite eine.

Ein Ausführungsbeispiel der Erfindung wird nachfolgend anhand der Zeichnung erläutert. Im einzelnen zeigt
- Fig. 1: die schematische Darstellung eines Bruchstücks eines Leiterplattenstreifens mit je drei Schaltungselementen pro Leiterplattenbereich,
- Fig. 2: die Draufsicht einer Solltrennzone mit Darstellung der Überführung einer besonders breiten Leitungsbahn,
- Fig. 3: die Draufsicht auf ein Stück eines Leiterplattenstreifens mit ebenfalls abbrechbaren Leiterplattenbereichen, deren Leitungsbahnen in wirklichkeitsgetreuem Layout gezeigt und die für je einen Befehlstaster und einen Klemmenblock vorgesehen sind und
- Fig. 4: einen Querschnitt eines Leiterplattenbereichs nach Fig. 3, wobei auch der betreffende Befehlstaster samt Lampe sowie der Klemmenblock dargestellt sind.

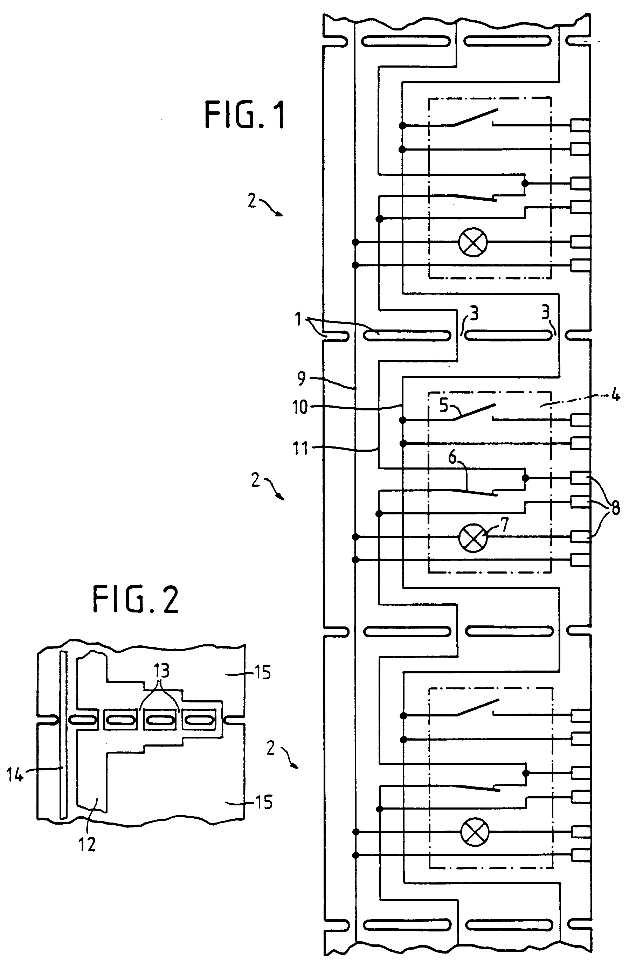

Der Leiterplattenstreifen nach Fig. 1 besteht aus Isolierstoff und ist durch quer verlaufende Schlitze 1 in einzelne Leiterplattenbereiche 2 gegliedert, die über je drei abbrechbare Stege 3 zusammenhängen. Jeder der Leiterplattenbereiche 2 ist mit einer durch eine strichpunktierte Umrahmung dargestellten Komponente 4 bestückt, welche drei Schaltungselemente enthält, nämlich zwei Schalter, von denen einer als Schließer 5 und der andere als Öffner 6 wirkt, und eine Lampe 7.

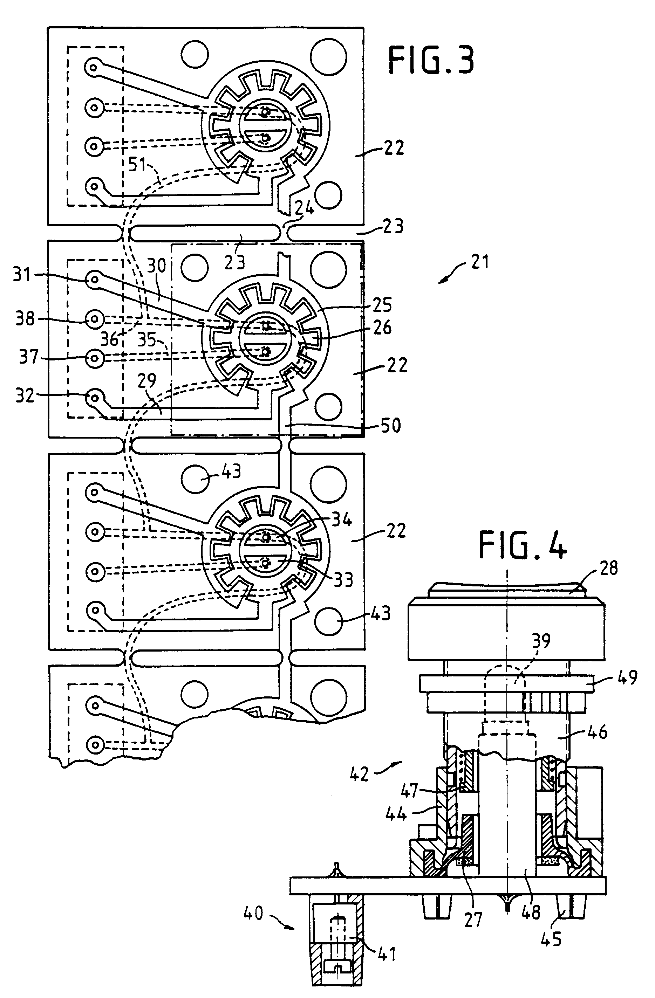

Die Schaltungsanordnung der Leiterplattenbereiche 2 ist im Gegensatz zu der Darstellungsart nach Fig. 3 schematisch wiedergegeben. Die Leitungen kreuzen sich. In Wirklichkeit sind die einzelnen Anschluß- und Verzweigungspunkte durchkontaktierbar, so daß durch frei wählbare Leitungsführung auf der einen oder anderen Seite der Leiterplatte die Kreuzungen vermieden werden können. Jeder Leiterplattenbereich 2 hat eine Anschlußeinrichtung in Form von sechs an einem Seitenrand nebeneinander liegenden verbreiterten Leitungsbahnenden 8. Jedes Schaltungselement ist mit zwei Leitungsbahnenden 8 verbunden und über dieses von außen anschließbar.

Abgesehen von diesen sechs internen Leitungsverbindungen auf jedem Leiterplattenbereich 2 gibt es zwei durchgehende Verbindungen 9 und 10, die über die Stege 3 und über die ganze Länge des Leiterplattenstreifens geführt sind. Die Verbindung 9 ist mit dem einen Anschluß sämtlicher Lampen 7 und die Verbindung 10 mit einem Anschluß sämtlicher Schließer 5 verbunden. Schließlich gibt es Brückenverbindungen 11, die ebenfalls über die Solltrennzonen geführt sind und jeweils einen Anschluß eines Öffners 6 mit dem anderen Anschluß des benachbarten Öffners 6 verbinden.

Wird ein derartiger Leiterplattenstreifen beliebiger Länge installiert und sollen die Öffner 6 zu einem Ruhestromkreis in Reihe geschaltet werden, so genügt es, am dritten Leitungsbahnende 8 des ersten Leiterplattenbereichs 2 und am vierten Leitungsbahnende 8 des letzten Leiterplattenbereichs 2 einen Zuleitungsdraht anzuschließen. Ferner muß der eine Pol der Stromquelle für die Lampen 7 an irgendeiner Anschlußeinrichtung an dem Leitungsbahnende 8 angeschlossen werden, das mit der durchgehenden Verbindung 9 zusammengeschaltet ist. In gleicher Weise wird einmal, d. h. nur an einer Anschlußeinrichtung der Anschluß der durchgehenden Verbindung 10 für die Schließer 5 geschaffen. Lediglich für die Lampen 7 und die Schließer 5 sind dann noch individuelle Anschlüsse vorzunehmen. Sieht man von den vier gemeinsamen Anschlußvorgängen ab, so ist festzustellen, daß infolge der über die Solltrennzonen durchgehenden Verbindungen bei den einzelnen Leiterplattenbereichen 2 nur zwei von sechs Anschlußvorgängen durchgeführt werden müssen. Dies bedeutet eine Verringerung der Verdrahtungszeit auf nahezu 1/3.

Fig. 2 soll deutlich machen, daß auch eine breite, für höhere Strombelastungen ausgelegte Leitungsbahn 12 als durchgehende Leitungsbahn über schmale Stege geführt werden kann, indem man sie in Zweigbahnen 13 geringeren Querschnitts verzweigt. Daneben ist noch eine weitere durchgehende Leitungsbahn 14 auf den ansonsten nur angedeuteten Leiterplattenbereichen 15 vorgesehen.

Der insgesamt mit 21 bezeichnete Leiterplattenstreifen nach Fig. 3 ist durch Querschlitze 23 in einzelne Leiterplattenbereiche 22 gegliedert, die über je zwei Stege 24 zusammenhängen. Dies ist an einer Stelle der Fig. 3 durch Unterbrechung einer über den Steg 24 führenden Leitungsbahn deutlicher dargestellt.

Alle Leiterplattenbereiche 22 sind auf beiden Seiten mit Leitungsbahnen versehen. Die Leitungsbahnen auf der nicht sichtbaren Unterseite sind gestrichelt dargestellt. Auf der Oberseite befinden sich je zwei ineinander verzahnte konzentrische Leitungsbahnabschnitte 25 und 26, die durch Aufdrücken eines Membrankörpers 27 mittels einer Taste 28 leitend miteinander verbunden werden können. Diese Leitungsbahnabschnitte sind über Leitungsbahnen 29 und 30 mit Anschlußrondellen 31 und 32 verbunden.

Innerhalb der Leitungsbahnabschnitte 26 befinden sich zwei halbmondförmige Kontaktierungsflächen 33 und 34, die durchkontaktiert und auf der Unterseite mittels Leitungsbahnen 35 und 36 an Anschlußrondelle 37 und 38 geführt sind. An den Kontaktierungsflächen 33 und 34 sind die Anschlüsse einer Lampe 39 angelötet, die im Befehlstaster eingebaut ist und die Taste 28 von innen beleuchtet.

Die vier Anschlußrondelle jedes Leiterplattenbereichs 22 liegen am linken Rand in einer Reihe. An dieser Stelle ist von unten her ein Klemmenblock 40 mit je vier Schraubklemmen 41 angesetzt. Je eine Schraubklemme ist an ein Anschlußrondell angelötet, wodurch der Klemmenblock 40 auch mechanisch hält.

Fig. 4 zeigt einen Befehlstaster 42 wie er an jedem Leiterplattenbereich 22 mit Hilfe von zwei Befestigungsbohrungen 43 angebracht ist. In Fig. 3 ist nur ein Befehlstaster 42 durch ein strichpunktiertes Quadrat angedeutet. Der Befehlstaster besteht aus einem Tragstück 44, dessen Kunststoffsplinte 45 durch die Befestigungsbohrungen 43 greifen und welches den ringförmigen, gummielastischen Membrankörper 27 umschließt und hält. In dem Tragstück 44 steckt ein Betätigergehäuse 46, welches die Taste 28 führt. Bei Betätigung der Taste drückt diese mit ihrem rohrförmigen Stößelende 47 auf den Membrankörper 27. Ganz innen befindet sich die Fassung 48 der vorerwähnten Lampe 39, deren Anschlußstifte mit den Kontaktierungsflächen 33 und 34 verlötet sind.

Jeder der dargestellten Leiterplattenbereiche 22 bildet zusammen mit seinem Befehlstaster 42 und seinem Klemmenblock 40 ein für sich funktionsfähiges Schaltgerät, an dem hierzu vier Leitungen angeschlossen werden müssen, zwei für den Schließerkontakt und zwei für die Lampe. Die Befestigung erfolgt in der Weise, daß das Tragstück 44 von dem Betätigergehäuse 46 abgenommen und dieses in eine nicht dargestellte Tragwand eingesteckt und mit einem Schraubring 49 festgeklemmt wird. Werden solche Schaltgeräte reihenweise eingebaut, wie z. B. bei Aufzugssteuerungen, so wird ein Leiterplattenstreifen 21 durch Abbrechen nicht benötigter Leiterplattenbereiche an den Stegen 24 auf die gewünschte Länge bzw. Betätigeranzahl verkürzt. Durch das Ansetzen des ganzen Streifens vereinfacht sich die Montage, jedoch noch nicht die Verdrahtungsarbeit, da bei dem insoweit beschriebenen Leiterplattenstreifen 21 an jedem Klemmenblock 40 vier Drähte angeklemmt werden müssen.

Um die Zahl der anzuklemmenden Drähte zu verringern, sind die Leitungsbahnabschnitte 25 allesamt untereinander durch Verbindungs-Leitungsbahnen 50 miteinander verbunden, die auf der Oberseite der Leiterplattenbereiche 22 über den jeweils rechten Steg 24 geführt sind. Ferner sind die Kontaktierungsflächen 34 über Verbindungs-Leitungsbahnen 51 ebenfalls allesamt miteinander verbunden, wobei die Verbindungs-Leitungsbahnen 51 auf der Unterseite der Leiterplattenbereiche 22 über die jeweils linken Stege 4 geführt sind.

Auf diese Weise genügt es, bei einem zusammenhängenden Leiterplattenstreifen 21 nur an einem beliebigen Klemmenblock 40 an den Anschlußrondellen 38 und 31 zwei Zuleitungsdrähte (z. B. den Pluspol einer Stromquelle oder eine Sammelleitung) anzuklemmen. Die Versorgung der übrigen Leitungsbahnabschnitte 25 und Kontaktierungsflächen 24 erfolgt über die Verbindungs-Leitungsbahnen 50 und 51. Ansonsten sind nur noch an den Schraubklemmen der Anschlußrondelle 32 und 37 die individuellen Zuleitungsdrähte anzuklemmen.

## Patentansprüche

1. Elektrische Leiterplatte von streifenförmiger Gestalt mit mehreren gleich großen Leiterplattenbereichen, die durch Solltrennzonen quer abgeteilt und mit wenigstens einem Schaltungselement und einer Anschlußeinrichtung versehen sind, dadurch gekennzeichnet, daß die Schaltungselemente (5, 6, 7) sowie die Anschlußeinrichtungen (8) aller Leiterplattenbereiche (2) durch über die jeweiligen Solltrennzonen geführte Leitungsbahnen (9, 10, 11) miteinander verbunden sind.

2. Leiterplatte nach Anspruch 1, dadurch gekennzeichnet, daß die Solltrennzonen durch schmale Verbindungsstege (3; 24) und Schlitze (1; 23) gebildet sind.

3. Leiterplatte nach Anspruch 1, dadurch gekennzeichnet, daß gemeinsame, über die Solltrennzonen geführte Leitungsbahnen (9, 10; 50, 51) vorgesehen sind, an denen einander entsprechende Schaltungselemente aller Leiterplattenbereiche zusätzlich angeschlossen sind.

4. Leiterplatte nach Anspruch 1, dadurch gekennzeichnet, daß gemeinsame, über die Solltrennzonen geführte Leitungsbahnen (11) vorgesehen sind, die einander entsprechende Schaltungselemente (6) aller Leiterplattenbereiche (2) zu einer Reihenschaltung verbinden.

5. Leiterplatte nach einem der Ansprüche 3 oder 4, dadurch gekennzeichnet, daß eine gemeinsame Leitungsbahn (12) im Bereich der Solltrennzonen in mehrere parallele Zweigbahnen (13) geringeren Querschnitts aufgeteilt ist.

## Claims

1. Electric printed circuit board of strip-shaped form with a plurality of equal-sized printed circuit board regions which are transversely divided by predetermined separation zones and are provided with at least one circuit element and one connecting device, characterised in that the circuit elements (5, 6, 7) and the connecting devices (8) of all printed circuit board regions (2) are connected to one another by conductor paths (9, 10, 11) guided over the respective predetermined separation zones.

2. Printed circuit board according to claim 1, characterised in that the predetermined separation zones are formed by narrow connecting webs (3; 24) and slots (1; 23).

3. Printed circuit board according to claim 1, characterised in that common conductor paths (9, 10; 50, 51) guided over the predetermined separation zones are provided, to which mutually corresponding circuit elements of all printed circuit board regions are additionally attached.

4. Printed circuit board according to claim 1, characterised in that common conductor paths (11) guided over the predetermined separation zones are provided, which connect mutually corresponding circuit elements (6) of all printed circuit board regions (2) to form a series circuit.

5. Printed circuit board according to one of claims 3 or 4, characterised in that a common conductor path (12) is divided into a plurality of parallel branch paths (13) of smaller cross section in the region of the predetermined separation zones.

## Revendications

1. Carte imprimée électrique, en forme de bande, comportant plusieurs zones de carte imprimée de taille identique, qui sont séparées transversalement par des zones de séparation nominales et qui sont au moins munies d'un élément de circuit et d'un dispositif de raccord,
caractérisée en ce que les éléments de circuit (5,6,7), ainsi que les dispositifs de raccord (8), relient ensemble toutes les zones de carte imprimée (2), par l'intermédiaire de lignes de conduction (9,10,11) traversant les zones de séparation nominales respectives.

2. Carte imprimée selon la revendication 1,
caractérisée en ce que les zones de séparation nominales sont formées par des ponts de liaison étroits (3;24) et des fentes (1;23).

3. Carte imprimée selon la revendication 1,
caractérisée en ce que des lignes de conduction communes (9,10;50,51) traversant les zones de séparation nominales sont prévues, auxquelles lignes de conduction des éléments de circuit correspondants de toutes les zones de carte imprimée sont de plus rattachés.

4. Carte imprimée selon la revendication 1,
caractérisée en ce que des lignes de conduction communes (11) traversant les zones de séparation nominales sont prévues, lignes de conduction qui relient ensemble, en un montage en série, des éléments de circuit correspondants (6) de toutes les zones de carte imprimée (2).

5. Carte imprimée selon une des revendications 3 ou 4,
caractérisée en ce qu'une ligne de conduction commune (12) est divisée, dans la région des zones de séparation nominales, en plusieurs branches parallèles (13) de section transversale réduite.
